Europäisches Patentamt

European Patent Office

Office européen des brevets

(19)

(11) Veröffentlichungsnummer: **0 316 844**

**A1**

# (12) EUROPÄISCHE PATENTANMELDUNG

(21) Anmeldenummer: **88118956.7**

(22) Anmeldetag: **14.11.88**

(51) Int. Cl.⁴: **C04B 35/00 , C04B 35/60 , H01L 39/12**

(30) Priorität: **18.11.87 DE 3739258**

(43) Veröffentlichungstag der Anmeldung:
**24.05.89 Patentblatt 89/21**

(84) Benannte Vertragsstaaten:
**DE FR GB IT NL**

(71) Anmelder: **BAYER AG
Konzernverwaltung RP Patentabteilung
D-5090 Leverkusen 1 Bayerwerk(DE)**

(72) Erfinder: **Eiling, Aloys, Dr.
Schmiedestrasse 12
D-4630 Bochum 6(DE)**
Erfinder: **Meisen, Ulrich, Dr.
Breslauerstrasse 13
D-4150 Krefeld 11(DE)**
Erfinder: **Woditsch, Peter, Dr.
Deswatinestrasse 83
D-4150 Krefeld 11(DE)**

(54) **Hochtemperatursupraleiter, Verfahren zu ihrer Herstellung sowie deren Verwendung.**

(57) Die vorliegende Erfindung betrifft supraleitende Stoffe mit einer Sprungtemperatur (Tc) von mehr als 77 K der allgemeinen Zusammensetzung:

$M(I)_x M(II)_y M(III)_z O_w X_v$, wobei

M(I) : ein Element aus der Gruppe Ba, Sr, Ca, Pb,

M(II) : ein Element aus der Gruppe der Seltenen Erden (RE) sowie Y,

M(III) : ein Element aus der Gruppe der Übergangsmetalle,

X ein Element aus der Gruppe N, Cl, F ist und

$0 < x < 3,0$
$0 < y < = 3,0$
$2,0 < z < = 4,0$
$3,0 < w < = 9,0$
$0 < v < = 3,0$

bedeutet.

EP 0 316 844 A1

## Hochtemperatursupraleiter, Verfahren zu ihrer Herstellung sowie deren Verwendung

Die vorliegende Erfindung betrifft supraleitende Stoffe mit einer Sprungtemperatur (Tc) von mehr als 77 K der allgemeinen Zusammensetzung:
$M(I)_x M(II)_y M(III)_z O_w X_v$, wobei
M(I) : ein Element aus der Gruppe Ba, Sr, Ca, Pb,
M(II) : ein Element aus der Gruppe der Seltenen Erden (RE) sowie Y,
M(III) : ein Element aus der Gruppe der Übergangsmetalle,
X ein Element aus der Gruppe N, Cl, F ist und
$0 < x < 3,0$
$0 < y < = 3,0$
$2,0 < z < = 4,0$
$3,0 < w < = 9,0$
$0 < v < = 3,0$
bedeutet. Verfahren zur Herstellung dieser supraleitenden Stoffe sowie deren Verwendung.

Supraleitende Verbindungen sind Stoffe, die unterhalb einer bestimmten Temperatur, der sogenannten Sprungtemperatur (Tc), keinen meßbaren elektrischen Widerstand aufweisen. (Physical Review B. Vol. 35, Nr. 16, 1987, Seiten 8782-4.)

Diese Verbindungen werden insbesondere zur Erzeugung höchster Magnetfelder eingesetzt. Weitere Anwendungsgebiete für supraleitende Verbindungen sind Energiespeicherung, Energieübertragung und Energieerzeugung, sowie ihr Einsatz für Sensorik und Digitaltechnik (Schaltkreise).

Ein wesentlicher Vorteil einer Anwendung von Systemen mit supraleitenden Materialien liegt darin, daß Ströme verlustfrei und somit permanent fließen können. Ein weiterer Vorteil liegt in einer hohen spezifischen Stromtragfähigkeit derartiger Materialien, die deutlich über der Stromtragfähigkeit konventioneller Kupferleitungen liegt.

Der entscheidende Nachteil bisher eingesetzter Supraleiter ist ihre sehr niedrige kritische Temperatur von 10 - 23 K. Bedingt durch diesen niedrigen Wert der Sprungtemperatur (Tc) müssen Systeme mit konventionellen Supraleitern (NbTi, $Nb_3Sn$, MoN etc.) mit flüssigem Helium gekühlt werden.

Seit Ende 1986 wurden neuartige supraleitende Materialien gefunden, die deutlich höhere kritische Temperaturen aufweisen. Die erste Mitteilung über derartige Verbindungen im System Ba-La-Cu-O findet sich in Zeitschrift f. Physik B 64 (1986), 189; J.G. Bednorz und K.A. Müller. Seit dem Erscheinen dieser Arbeit wurde sehr viel über neuartige oxidische Supraleiter publiziert.

Zur Herstellung dieser Materialien wird in der Regel von Gemischen der Oxide, Peroxide oder Carbonate der entsprechenden Metalle ausgegangen, wobei diese dann gemischt, zu Pillen verpreßt und unter Luft oder Sauerstoff geglüht werden.

Eine derartige Technik ist jedoch nicht zur Herstellung von Halbzeug mit ausreichender mechanischer Festigkeit bzw. Stromtragfähigkeit geeignet.

In supraleitenden Spulen treten bei der Erzeugung höchster Magnetfelder sehr hohe Zugkräfte auf, die durch das Material aufgenommen werden müssen. Nach den bekannten keramischen Verfahren hergestellte Materialien zeichnen sich durch Sprödigkeit, geringe Biegefestigkeit und Zugfestigkeit aus, da sie aus groben Körnern mit einer mittleren Teilchengröße von mehr als 1 mym bestehen.

Zur Herstellung derartigen Halbzeugs finden derzeit Verfahren wie Aufdampfen oder Aufsputtern vielfach Anwendung. (Physical Review B, Vol. 35, Nr. 16, 1987, Seiten 8821-3.) Bei diesen Verfahren muß jedoch im Höchstvakuum gearbeitet werden, was die Kosten pro Einheit stark erhöht. Weiterhin ist die Größe der zu behandelnden Werkstücke durch die Größe der Behandlungsapparaturen begrenzt. Die Abscheiderate ist bei derzeitigen Sputterverfahren gering, so daß nur eine geringe Stückzahl pro Zeiteinheit hergestellt werden kann. Ein MOCVD-Prozeß (Zersetzung von metallorganischen Komplexen auf erhitzten Substraten) zeichnet sich durch sehr hohe Kosten für die in der Regel sehr luft- und wasserempfindlichen metallorganischen Komplexe aus. Nach diesem Verfahren werden im allgemeinen auch nur dünne Schichten erhalten. Nachteile zeigen auch Sol-Gel-Prozesse, bei denen in der Regel von Alkoxiden der entsprechenden Metalle ausgegangen wird, die nur durch sehr aufwendige und daher teure Verfahren hergestellt werden können. Der bei der Umwandlung auftretende Volumenschwund läßt diesen Prozeß nur bedingt geeignet erscheinen, um großvolumige Körper herzustellen.

Es ist also Ziel dieser Erfindung, ein supraleitendes Material zur Verfügung zu stellen, das diese Nachteile nicht aufweist und zur Herstellung von entsprechendem Halbzeug - wie Draht - geeignet ist.

Es wurde nun gefunden, daß diese Anforderungen in hervorragender Weise erfüllt werden durch supraleitende Stoffe mit einer Sprungtemperatur (Tc) von mehr als 77 K der allgemeinen Zusammensetzung
$M(I)_x M(II)_y M(III)_z O_w X_v$, wobei
M(I) : ein Element aus der Gruppe Ba, Sr, Ca, Pb,
M(II) : ein Element aus der Gruppe der Seltenen Erden (RE) sowie Y,
M(III) : ein Element aus der Gruppe der Übergangsmetalle,
X ein Element aus der Gruppe N, Cl, F ist und
$0 < x < 3,0$

$0 < y < = 3,0$
$2,0 < z < = 4,0$
$3,0 < w < = 9,0$
$0 < v < = 3,0$

bedeutet, wobei die supraleitenden Stoffe eine Dichte von > 99 % der theoretischen Dichte aufweisen.

Diese supraleitenden Stoffe sind Gegenstand dieser Erfindung. Die theoretische Dichte läßt sich bei Kenntnis der Kristallstruktur aus der Anzahl der Formeleinheiten, dem Zellvolumen und dem mittleren Atomgewicht berechnen. In einer besonders bevorzugten Ausführungsform ist bei den erfindungsgemäßen supraleitenden Stoffen M (III) ein Element aus der Gruppe Cu, Ag, Mn, Ni, Pd, Pt oder eine Kombination dieser Elemente.

Die erfindungsgemäßen supraleitenden Stoffe bieten den Vorteil, daß zu ihrer Verwendung aufgrund ihrer hohen Sprungtemperatur eine Kühlung mit flüssigem Stickstoff ausreicht. Die erfindungsgemäßen Supraleiter führen zu Halbzeug mit besseren mechanischen und elektrischen Eigenschaften.

Gegenstand dieser Erfindung ist auch ein Verfahren zur Herstellung der erfindungsgemäßen supraleitenden Stoffe. Dies ist dadurch gekennzeichnet, daß eine der Zusammensetzung des supraleitenden Stoffes entsprechende Verbindung oder eine Mischung von Ausgangsmaterialien, die unter den Herstellungsbedingungen zu der Zusammensetzung des supraleitenden Stoffes führt, aufgeschmolzen und diese Schmelze im flüssigen oder erstarrten Zustand in dünne Körper zerteilt wird und die erstarrten dünnen Körper getempert werden.

Dieses Verfahren besteht somit aus mehreren Schritten, die wie folgt durchgeführt werden können:

1. Mischen der Komponenten entsprechend der angestrebten Zusammensetzung des Supraleiters. Hierbei können konventionelle Mischaggregate, wie Kugelmühlen oder ein Pflugscharmischer etc. Verwendung finden.

2. Schmelzen dieser Mischung in einem Tiegel aus einem Material, das von der Schmelze nicht angegriffen wird und damit die Zusammensetzung der Schmelze nicht ändert. Bewährt haben sich Tiegel aus BaO, Pt, MgO sowie Erdalkalititanaten, z.B. $MgTiO_3$, $Mg_2TiO_4$, $MgTi_2O_5$, $SrTiO_3$, $BaTiO_3$.

3. Abkühlen oder Abschrecken der Schmelze.

4. Zerteilen der Schmelze in die gewünschten Formkörper durch Sägen, Fräsen, Schleifen, Funkenerodieren oder ähnliche Techniken oder Verspinnen der Schmelze zu Fasern, Drähten oder anderen Formkörpern.

5. Erhitzen des Formkörpers auf eine Temperatur unterhalb des Schmelzpunkts der Phase.

6. Abkühlen des Formkörpers.

Eine bevorzugte Ausführungsform des erfindungsgemäßen Verfahrens besteht darin, daß die dünnen Körper eine Dicke von mehr als 1 μm aufweisen. Besonders vorteilhaft ist das Verfahren durchführbar, wenn die flüssige Schmelze durch einen Fadenziehprozeß in dünne Fäden umgewandelt wird. Die erfindungsgemäße Temperung der dünnen Körper wird vorteilhaft in einer Atmosphäre aus Inertgasen und/oder $N_2$, $O_2$, $Cl_2$, $F_2$ bei Temperaturen von 300 bis 1.000 °C, bevorzugt 600 bis 800 °C vorgenommen.

Die abschließende Abkühlung wird ebenfalls bevorzugt in einer Atmosphäre aus Inertgasen und/oder $N_2$, $O_2$, $Cl_2$, $F_2$ anschließt, die mit einer Geschwindigkeit von 0,01 bis 10 K/min und 0,1 bis 1000 bar Gasdruck linear oder in mehreren Schritten vorgenommen.

Ein Vorteil des erfindungsgemäßen Verfahrens liegt in der einfachen und sehr wirtschaftlichen Verfahrensweise. Es können auf diese Weise mechanisch belastbare Formkörper mit besseren elektrischen Eigenschaften als durch das bekannte keramische Verfahren erhalten werden.

Gegenstand dieser Erfindung ist auch die Verwendung der erfindungsgemäßen supraleitenden Stoffe zur Erzeugung hoher Magnetfelder, zur Informationsverarbeitung und Informationsübertragung sowie als Halbzeug für Anlagen zur Energieübertragung, Energieumwandlung, Energieerzeugung oder Energiespeicherung.

Die folgenden Beispiele sollen die Erfindung verdeutlichen, ohne sie jedoch einzuschränken, insbesondere wird der Fachmann durch Variation von Art und Menge der Metalle M(I), M(II) und M(III) sowie von X jede gewünschte Zusammensetzung mühelos erhalten.

Beispiel 1

265,8 g $BaCO_3$ (99 %ig), 222,2 g $CuCO_3 \bullet Cu(OH)_2$ (99,5 %ig) und 75,3 g $Y_2O_3$ (99,99 %ig) wurden in einem Mischer sorgfältig gemischt und zu Tabletten verpreßt. Diese Tabletten werden in einer Pt-Schale innerhalb von 3 h auf 1200 °C aufgeheizt, 10 h bei dieser Temperatur belassen und auf Raumtemperatur mit 4 k/min abgekühlt.

Die so erhaltenen Tabletten wurden mit einer Innenlochsäge zu Scheiben von 400 mym gesägt und anschließend in einer Atmosphäre von 130 1/h Sauerstoff und 70 1/h Argon auf 900 °C aufgeheizt und in 209 Minuten auf 120 °C abgekühlt.

Es wurde eine schwarze supraleitende Phase mit Tc: 94 K erhalten. Die kritische Temperatur wurde durch Messung der Suszeptibilität gegen die Temperatur bestimmt.

Beispiel 2

Eine gemäß Beispiel 1 hergestellte Tablette wurde in 200 mym dicke Scheiben gesägt und in einer reinen Sauerstoffatmosphäre auf 400°C aufgeheizt und in 226 min von 400°C auf 40°C abgekühlt. Es wurde eine supraleitende Phase mit Tc: 94 K erhalten.

Das Zellvolumen der Phase mit einer Zusammensetzung $Ba_{2,0}Y_{1,0}Cu_{3,0}O_{7,0}$ betrug 0,1734 $nm^3$, woraus sich eine Röntgendichte von 6.403 $g/cm^3$ errechnet. Pyknometrisch (Sperrflüssigkeit: Petroleum) wurden 6.370 $g/cm^3$ gefunden, woraus sich eine Dichte von 99.4 % der Röntgendichte errechnet.

**Ansprüche**

1. Supraleitende Stoffe mit einer Sprungtemperatur (Tc) von > 77 K der allgemeinen Zusammensetzung:

$M(I)_x M(II)_y M(III)_z O_w X_v$, wobei

M(I) : ein Element aus der Gruppe Ba, Sr, Ca, Pb,

M(II) : ein Element aus der Gruppe der Seltenen Erden (RE) sowie Y,

M(III) : ein Element aus der Gruppe der Übergangsmetalle,

X eine Element aus der Gruppe N, Cl, F ist und

$0 < x < 3,0$

$0 < y < = 3,0$

$2,0 < z < = 4,0$

$3,0 < w < = 9,0$

$0 < v < = 3,0$

bedeutet, dadurch gekennzeichnet, daß die supraleitenden Stoffe eine Dichte von > 99 % der theoretischen Dichte aufweisen.

2. Supraleitende Stoffe gemäß Anspruch 1, dadurch gekennzeichnet, daß M (III) ein Element aus der Gruppe Cu, Ag, Au, Ni, Pd, Pt oder eine Kombination dieser Elemente ist.

3. Verfahren zur Herstellung der supraleitenden Stoffe gemäß einem der Ansprüche 1 oder 2, dadurch gekennzeichnet, daß eine der Zusammensetzung des supraleitenden Stoffes entsprechende Verbindung oder eine Mischung von Ausgangsmaterialien, die unter den Herstellungsbedingungen zu der Zusammensetzung des supraleitenden Stoffes führt, aufgeschmolzen und diese Schmelze im flüssigen oder erstarrten Zustand in dünne Körper zerteilt wird und die erstarrten dünnen Körper getempert werden.

4. Verfahren gemäß Anspruch 3, dadurch gekennzeichnet, daß die dünnen Körper eine Dicke von mehr als 1 μm aufweisen.

5. Verfahren gemäß einem der Ansprüche 3 oder 4, dadurch gekennzeichnet, daß die flüssige Schmelze durch einen Fadenziehprozeß in dünne Fäden umgewandelt wird.

6. Verfahren gemäß einem oder mehrerer der Ansprüche 3 bis 5, dadurch gekennzeichnet, daß die dünnen Körper in einer Atmosphäre aus Inertgasen und/oder $N_2$, $O_2$, $Cl_2$, $F_2$ bei Temperaturen von 300 bis 1000°C, bevorzugt 600 bis 800°C, getempert werden.

7. Verfahren gemäß Anspruch 6, dadurch gekennzeichnet, daß sich an die Temperung eine Abkühlung in einer Atmosphäre aus Inertgasen und/oder $N_2$, $O_2$, $Cl_2$, $F_2$ anschließt, die mit einer Geschwindigkeit von 0,01 bis 10 K/min und 0,1 bis 1000 bar Gasdruck linear oder in mehreren Schritten vorgenommen wird.

8. Verwendung der supraleitenden Stoffe gemäß einem oder mehrerer der Ansprüche 1 bis 7 zur Erzeugung hoher Magnetfelder.

9. Verwendung der supraleitenden Stoffe gemäß einem oder mehrerer der Ansprüche 1 bis 7 zur Informationsverarbeitung und Informationsübertragung.

10. Verwendung der supraleitenden Stoffe gemäß einem oder mehrerer der Ansprüche 1 bis 7 als Halbzeug für Anlagen zur Energieübertragung, Energieumwandlung, Energieerzeugung oder Energiespeicherung.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X,P | EP-A-0 283 024 (SUMITOMO ELECTRIC IND. LTD)<br>* Ansprüche 1-15; Seite 2, Spalte 1, Zeile 40 - Spalte 2, Zeile 30; Seite 4, Spalte 1, Zeilen 25-44 *<br>--- | 1-6 | C 04 B 35/00<br>C 04 B 35/60<br>H 01 L 39/12 |
| X,P | EP-A-0 285 169 (SUMITOMO ELECTRIC IND. LTD)<br>* Ansprüche 1-6,8-19; Seite 3, Zeile 24 - Seite 4, Zeile 55 *<br>----- | 1-6 | |

RECHERCHIERTE SACHGEBIETE (Int. Cl.4)

C 04 B
H 01 L

Der vorliegende Recherchenbericht wurde für alle Patentansprüche erstellt

| Recherchenort | Abschlußdatum der Recherche | Prüfer |
|---|---|---|
| DEN HAAG | 22-02-1989 | LUETHE H. |